(19) Europäisches Patentamt
European Patent Office
Office européen des brevets

(11) EP 0 851 040 A1

(12) **EUROPEAN PATENT APPLICATION**
published in accordance with Art. 158(3) EPC

(43) Date of publication:
01.07.1998 Bulletin 1998/27

(21) Application number: 96928669.9

(22) Date of filing: 28.08.1996

(51) Int. Cl.⁶: **C23C 16/50**, C23C 14/24,
C30B 25/02, B01J 19/08,
H01L 21/205

(86) International application number:
PCT/JP96/02401

(87) International publication number:
WO 97/08361 (06.03.1997 Gazette 1997/11)

(84) Designated Contracting States:
DE FR GB NL

(30) Priority: 29.08.1995 JP 220497/95

(71) Applicant: KOMATSU LTD.
Minato-ku Tokyo 107 (JP)

(72) Inventor:
SAKURAGI, Shunichi
Kenkyusho of Komatsu Ltd.
Kanagawa 254 (JP)

(74) Representative:
Newstead, Michael John et al
Page & Hargrave
Temple Gate House
Temple Gate
Bristol BS1 6PL (GB)

(54) **SURFACE TREATMENT APPARATUS USING GAS JET**

(57) To improve the quality of a product subjected to a surface treatment, such as a film-coating treatment, a heater (5) in this apparatus heats and turns into plasma a gas (6) to be ejected onto the surface of an object (15) to be treated, the gas being thus put in a highly reactive condition (excited condition or active condition). The heated and plasma gas is adiabatically expanded by a rubber nozzle (1) so that it has a velocity of flow higher than a sound velocity. The gas (7) the velocity of flow of which is made higher than a sound velocity is ejected toward the surface of the object (15) to be treated. The gas (7) which has thus been heated, turned into plasma and put in a highly reactive condition reaches the object (15) at a supersonic speed in a short period of time. This apparatus is further provided with a nozzle outlet pressure regulating chamber (18) enclosing the outlet of the supersonic nozzle (1) and the object (15), and a chamber (19) enclosing an induction coil (5) and regulating the pressure in the vicinity of the induction coil (5), these chambers (18, 19) being separated.

**FIG.3**

EP 0 851 040 A1

## Description

### TECHNICAL FIELD

The present invention relates to a surface treatment apparatus using gas jet, for treating a surface of an object to be treated by spraying gas onto the surface of the object, and more particularly to a surface treatment apparatus which is suitable for use in forming a diamond thin film on tool chips or a semiconductor thin film on various types of substrate.

### BACKGROUND ART

Surface treatment technology is already available in the form of the induction plasma and DC plasma jet methods whereby gas is rendered into plasma and activated in order to improve its reactivity before being sprayed at high speed on to the surface which is to be treated. Applications of this technology include diamond coating.

Japanese Patent Application Laid-open Nos. 2-26895, 2-64097, 2-39421 and 2-296796 disclose this type of technology.

With thin film coating of this kind it is vital that once the gas has been rendered into plasma and is in a highly reactive state, it reaches the surface to be treated (treatment surface) at supersonic speed with as little delay as possible. Any delay in spraying means that it becomes impossible to maintain the highly reactive state (excitation state, active state), leading to reduced adhesion between the treatment surface and the reaction product, with consequent peeling and other disadvantages. It also slows down the rate of film formation, thus reducing operational efficiency.

Moreover, the temperature of the plasma gas is very high, and by the time it is sprayed on to the treatment surface, it must have been reduced to a temperature which the treatment surface is able to withstand. Spraying it without reducing the temperature could result in defective film processing of the treatment surface.

Another aspect is the fact that there must be no admixture of impurities within the highly reactive plasma gas.

Nevertheless, the technologies described in the above-mentioned Japanese Patent Application Laid-open Nos. 2-26895 and 2-64097 fail to fulfil the condition that spraying be completed in as short a time as possible because the nozzles which are employed are not of a structure which permits them to attain supersonic speeds.

Meanwhile, Japanese Patent Application Laid-open No 2-39421 describes a technology whereby the gas reaches supersonic speeds, but the configuration is such that two types of gas are sprayed on to the treatment surface through separate pipe lines (a double pipe line). In this case, the gas in the center, which is at a lower temperature, comes into contact with the peripheral high-temperature gas downstream from the heating unit, as a consequence of which there is no process of adiabatic expansion, and the method fails to fulfil the condition that a state of high reactivity be maintained while spraying is implemented.

Similarly, Japanese Patent Application Laid-open No 2-296796 lacks a process of adiabatic expansion because more gas is introduced downstream after the other gas has been rendered into plasma. In other words, while the introduction of more gas ensures adequate cooling, the flow rate does not increase sufficiently, and the method fails to fulfil the condition that spraying be completed in as short a time as possible.

Thus, no conventional technology has fulfilled all the conditions for thin-film treatment.

The authors of the present invention have already applied to patent an invention relating to a method of surface treatment and a device for use therein which make it possible to fulfil all the conditions for thin-film treatment and aim to improve both the operational efficiency and quality thereof (Japanese Patent Application No. 6-134467).

Experiments conducted on the invention described in the above-mentioned Japanese Patent Application No. 6-134467 have served to elucidate the following points.

Fig. 2 shows how in the device which forms the embodiment of the above-mentioned patent application an induction coil 5 for the purpose of heating the gas is located within the same vacuum chamber (coating chamber) 8 as the object 15 to be treated (to be film coated). This means that when the chamber is filled with the gas which forms the crude material, it becomes impossible to maintain a high degree of vacuum, and irregular discharges tend to occur between the wires of the coil. This leads to sputtering, which means that the components of the wire coil (eg copper) are discharged within the chamber in the form of impurities.

These impurities are incorporated into the film as impurities during the coating process, and this results in a marked decline in the performance of the film.

What is more, the occurrence of irregular discharges inhibits a stable power supply to the plasma within the nozzle 1.

It is a first object of the present invention, which has been designed in view of circumstances such as these, to provide a device whereby irregular discharges in the induction coil are eliminated, thus making it possible to improve the quality of the surface treatment and ensure a stable power supply to the plasma within the nozzle.

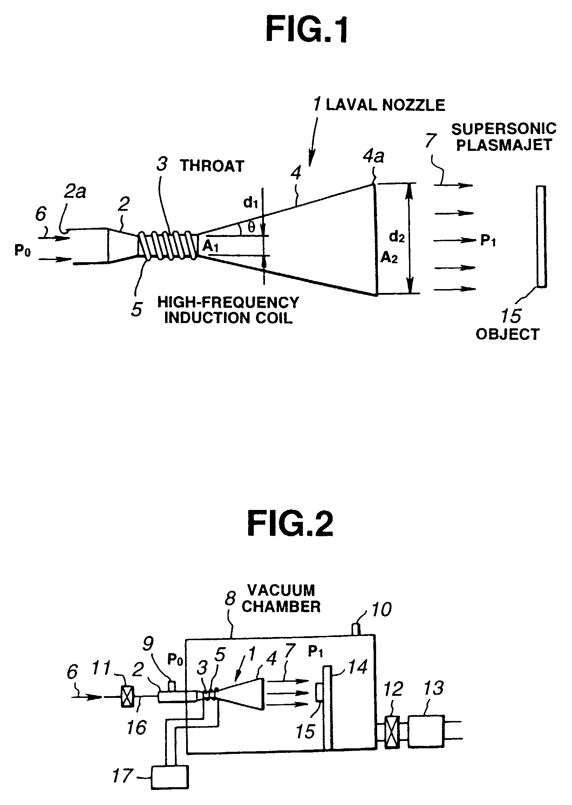

Moreover, it is desirable that the gas be sprayed from the supersonic nozzle 1 in the form of a supersonic plasma jet 7, as Fig. 1 shows.

However, depending on the stagnation pressure P0 of the gas 6 and the pressure P1 downstream from the spray outlet 4a (pressure within the coating chamber), the plasma jet becomes subsonic and the performance of the coating deteriorates markedly.

It is a second object of the present invention, which has been designed in view of circumstances such as these, to provide a device whereby it is possible to ensure that the plasma jet is supersonic, thus making it possible to improve the quality of the surface treatment.

In order to improve the quality of the object 15 to be treated, it is vital to increase the speed of the plasma jet which is sprayed on the object 15 to be treated and so to improve reaction efficiency.

It is a third object of the present invention, which has been designed in view of circumstances such as these, to provide a device whereby additional energy is injected into the plasma, thus making it possible to increase the speed of the plasma jet and improve the quality of the object 15 to be treated.

It is sometimes necessary to coat the object 15 with a film consisting of a metal or metal compound.

However, since metals and metal compounds cannot be rendered into gases, it is impossible to spray them on to the object 15 in the form of a gas.

It is a fourth object of the present invention to provide a device whereby even metals and metal compounds, which cannot be rendered into gases, can be sprayed on to treatment surfaces to form a metal or other coating.

There are also demands for improving the crystallinity of a thin film on the object 15. The improvement of crystallinity is achieved by ensuring that plasma particles reach the surface of the object 15 in a regular manner.

It is a fifth object of the present invention to provide a device whereby improved crystallinity is achieved by ensuring that plasma particles reach the surface of the object 15 in a regular manner.

DISCLOSURE OF THE INVENTION

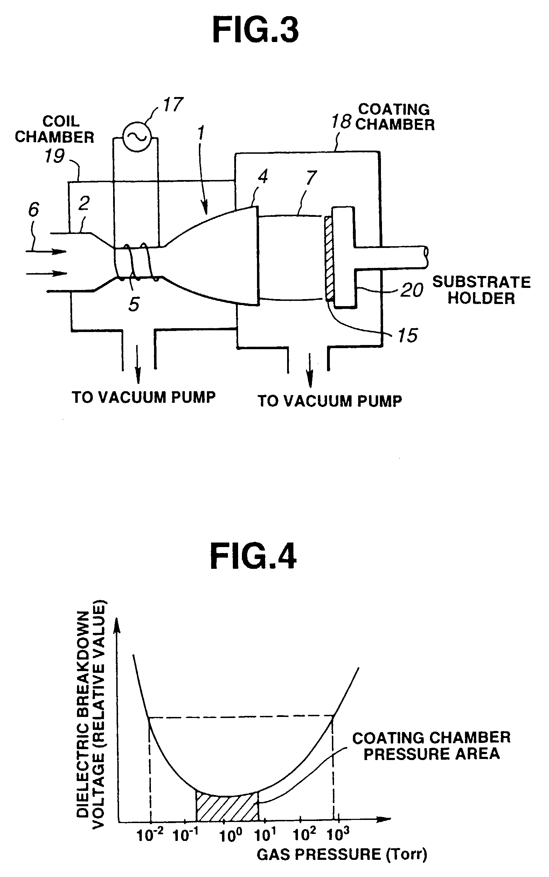

With a view to attaining the above-mentioned first object, the first aspect of the present invention as illustrated in Fig. 3 is configured so as to have chambers 18 and 19 for adjusting a pressure at the outlet of the supersonic nozzle 1 and a pressure in the vicinity of the conduction coil 5, the former being provided in such a manner as to surround the outlet of the nozzle and the object to be treated, and the latter being provided in such a manner as to surround the induction coil, the two chambers being separate.

It is also possible for it to be configured so as to have the chamber 18 for adjusting the pressure at the outlet of the supersonic nozzle located in such a manner as to surround the outlet of the nozzle 1 and the object 15 to be treated, while the induction coil 5 is open to the air.

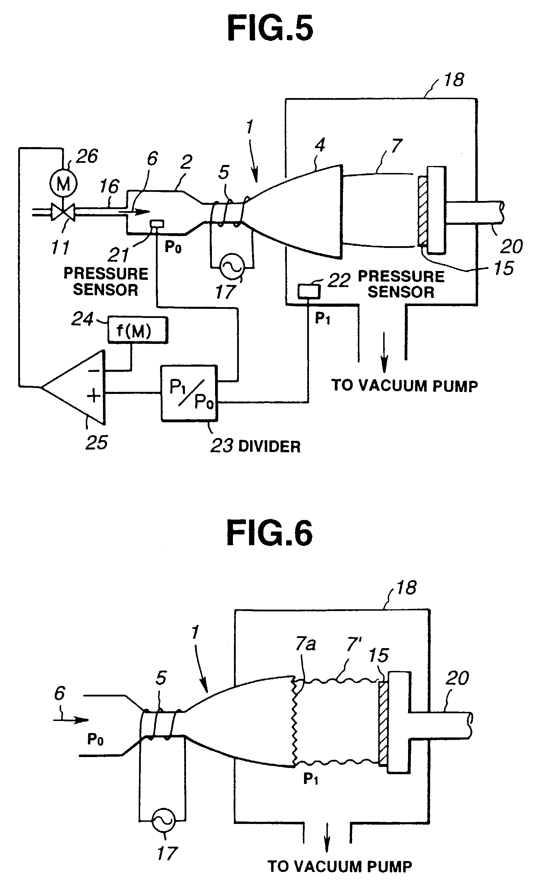

Meanwhile, with a view to attaining the above-mentioned second object, the second aspect of the present invention as illustrated in Fig. 5 is so configured that values of pressures P0 and P1 are adjusted so as to fulfill the following formula, where P0 is a stagnation pressure of the gas at a point of supply, P1 is a pressure at the outlet of the supersonic nozzle, M is a Mach number on the outlet surface of the supersonic nozzle, and $\gamma$ is a ratio of specific heat of the gas:

$$\frac{P_1}{P_0} < \left(1+\frac{\gamma-1}{2}M^2\right)^{\frac{-\gamma}{\gamma-1}}\left[\frac{2\gamma M^2 - (\gamma-1)}{\gamma+1}\right]$$

In this case it is possible, by controlling the flow rate of the gas 6 which is fed into the supersonic nozzle 1, to ensure that the conditions expressed by the formula are fulfilled.

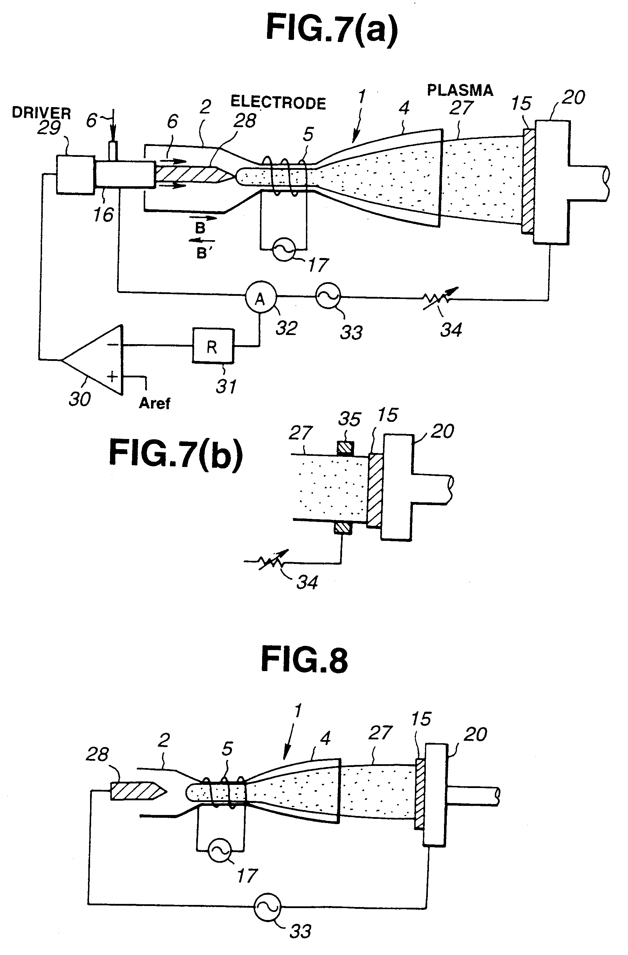

Meanwhile, with a view to attaining the above-mentioned third object, the third aspect of the present invention as illustrated in Fig. 7 (a) is so configured that electrodes 28 and 20 are provided at the inlet of the supersonic nozzle 1 and downstream of the outlet of the nozzle 1 respectively in such a manner as to come into contact with the plasma gas 27, and a prescribed voltage is applied across the electrodes 28 and 20.

In this case it is possible to provide driving means 29 for moving the electrode 28 at the inlet of the supersonic nozzle 1 in a direction of a flow of the plasma gas 27 and detection means 32 for detecting a plasma current, in which the electrode 28 at the inlet of the supersonic nozzle 1 is moved with the aid of the driving means 29 in such a manner that the plasma current attains a desired value.

Moreover, as Fig. 8 shows, it may be so configured that an electrode 20 is provided downstream from the outlet of the supersonic nozzle 1 in such a manner as to come into contact with the plasma gas 27, while another electrode 28 is provided at the inlet of the supersonic nozzle 1 in such a manner as not to come into contact with the plasma gas 27, and a prescribed voltage is applied across the electrodes 28 and 20.

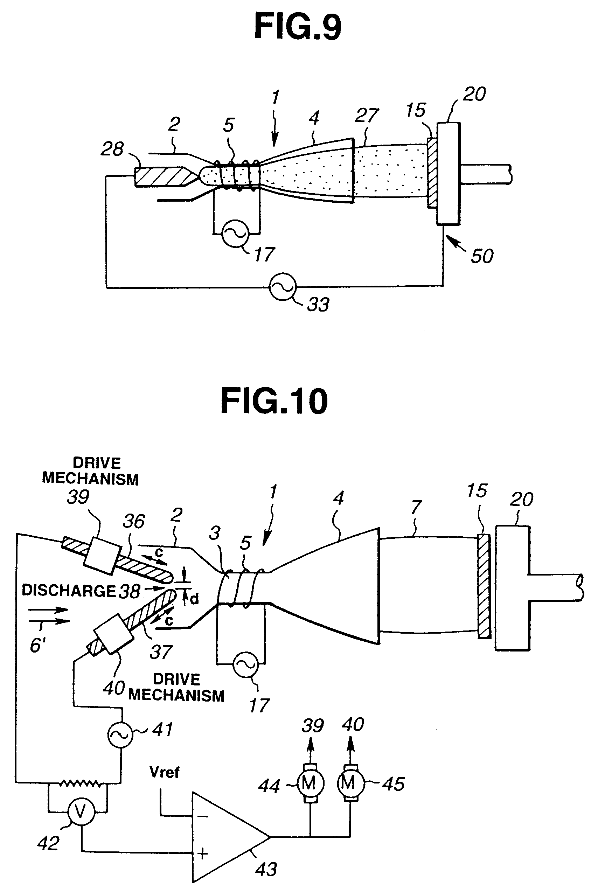

Meanwhile, with a view to attaining the above-mentioned fourth object, the fourth aspect of the present invention as illustrated in Fig. 10 is so configured that a carrier gas 6', which transports to the object 15 a raw material to be adhered to the surface of the object 15, is supplied into the supersonic nozzle 1 from the inlet of the nozzle 1 or from a gas supply position upstream along a path of gas flow from a position where the heating means 5 is located; two electrodes 36 and 37 configured with the raw material are located downstream from the position at which the carrier gas 6' is fed in; a discharge is effected across the two electrodes 36 and 37; the raw material, having been discharged from the two electrodes 36 and 37, is incorporated into the carrier gas 6'; the carrier gas 6' with the incorporated raw material is heated with the aid of the heating means 5 and rendered into plasma; and the plasma gas 7 is sprayed from the outlet of the nozzle toward the surface of the object 15.

In this case it is possible to provide driving means 39 and 40 for moving the two electrodes 36 and 37 so as to change a distance d between the electrodes 36 and 37, and detection means 42 for detecting a discharge voltage across the two electrodes 36 and 37, in which the two electrodes 36 and 37 are moved with the aid of the driving means 39 and 40 in such a manner that the discharge voltage attains a desired value.

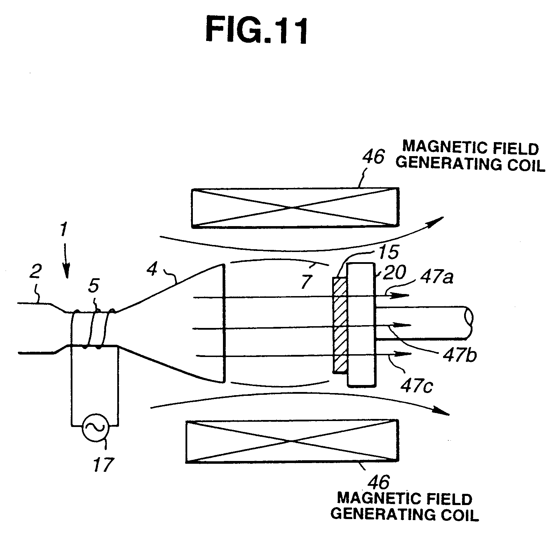

Meanwhile, with a view to attaining the above-mentioned fifth object, the fifth aspect of the present invention as illustrated in Fig. 11 is so configured that a magnetic field generating coil 46 is provided for forming mutually parallel magnetic lines 47a, 47b and 47c in a direction of a flow of the plasma gas 7 between the outlet of the supersonic nozzle 1 and the object 15 to be treated.

BRIEF DESCRIPTION OF THE DRAWINGS

Fig. 1 is a diagram illustrating the basic configuration of the gas spray surface treatment device to which the present invention pertains;
Fig. 2 is a diagram illustrating the configuration of the device illustrated in Fig. 1 to which a device for adjusting the nozzle outlet pressure has been fitted;
Fig. 3 is a diagram illustrating the configuration of the device described in the first embodiment, which corresponds to the first aspect of the present invention;
Fig. 4 is a graph illustrating Paschen s law;
Fig. 5 is a diagram illustrating the configuration of the device described in the second embodiment, which corresponds to the second aspect of the present invention;
Fig. 6 is a diagram used in order to explain the second embodiment;
Fig. 7 (a) and (b) are diagrams illustrating the configuration of the device described in the third embodiment, which corresponds to the third aspect of the present invention;
Fig. 8 is a diagram used in order to explain the third embodiment;
Fig. 9 is a diagram used in order to explain the third embodiment;
Fig. 10 is a diagram illustrating the configuration of the device described in the fourth embodiment, which corresponds to the fourth aspect of the present invention; and
Fig. 11 is a diagram illustrating the configuration of the device described in the fifth embodiment, which corresponds to the fifth aspect of the present invention.

BEST MODE FOR IMPLEMENTING THE INVENTION

There follow, with the aid of drawings, descriptions of the embodiments of the gas spray surface treatment device to which the present invention pertains.

Firstly, the basic configuration of the device will be explained with reference to Fig. 1.

Fig. 1 is a diagram illustrating the basic configuration of the device. As will be seen from the drawing, the supersonic Laval nozzle (or fan nozzle) 1 is configured under conditions which will be explained later in such a manner that gas passing through it undergoes adiabatic expansion and is sprayed from the outlet 4a at a flow rate u which is greater than the speed of sound a.

The shape of the Laval nozzle 1 is such that it converges and then diverges, being slender in the middle. It comprises a gas inlet pipe 2, a throat section 3 and a gas spray pipe 4. The gas inlet pipe 2 is configured in such a manner that the gas 6 (eg a mixture of $CH_4$ and $H_2$) which is to be sprayed on to the surface of the object 15 (eg of a cutting tool chip) is introduced from a gas inlet 2a, the cross-sectional area of the pipe becoming gradually smaller as the gas progresses. The throat section 3 has the smallest cross-sectional area A1 (diameter d1) of the whole nozzle, while the gas spray pipe 4 is configured in such a manner that the cross-sectional area gradually increases by a prescribed angle of diffusion θ until the gas 7 is sprayed from a gas spray outlet 4a, which has the greatest cross-sectional area A2 (diameter d2) downstream from the throat section. The Laval nozzle 1 is located in such a manner that the gas 7 is sprayed through the spray outlet 4a on to the surface of the object 15.

The throat section 3 is provided with an induction plasma device. In other words, an induction coil 5 is wound around the throat section 3 in such a manner that a high-frequency current can be passed through the induction coil 5. When electricity is passed through the coil 5 in this manner, an electromagnetic field is formed within the throat section 3, so that gas passing through the throat section 3 is heated and rendered into plasma. Thus, the induction plasma device is an electrode-less plasma device which makes use of an electromagnetic field. As a result it is possible to prevent the admixture of impurities, in contrast to a DC plasma device where the plasma and electrodes come into direct contact with each other, with resultant admixture of the electrode material (eg tungsten) as the electrodes are worn away.

Suppose that a high-density mixture gas 6 which is to be sprayed on to the object 15 is fed into the Laval nozzle 1 through the gas inlet 2a. As explained above, a high-frequency current is being passed through the high-frequency induction coil 5, generating an electromagnetic field, as a result of which energy the high-density gas is heated and rendered into plasma.

The high-density gas, having been heated and rendered into plasma, undergoes adiabatic expansion as the nozzle widens in the downstream gas spray pipe 4, and is sprayed from the gas spray outlet 4a in the form of a supersonic plasma jet 7.

According to the theory of gas dynamics, if in the case of a diatomic gas the ratio P1 / P0 of the stagnation pressure P0 of the gas 6 to the pressure P1 downstream from the spray outlet 4a is about 0.52 or less, and the ratio (fan ratio) A2 / A1 of the cross-sectional area A1 of the throat section 3 to the cross-sectional area A2 of the spray outlet 4a is in excess of 1, the gas undergoes adiabatic expansion, and the flow rate on spraying becomes supersonic. That is to say, the flow rate u becomes greater than the speed of sound a.

If the angle of diffusion θ before and after the throat section 3 is too great, boundary layer separation occurs on the wall surface. It should therefore be a suitable angle of, say, about 15°.

The high-density gas, having been heated and rendered into plasma in the throat section 3, is excited by the heat so as to be highly reactive, namely to react easily on the object 15. However, such highly reactive gas has a very high temperature, sometimes well in excess of 10,000°, and it sometimes happens that the treatment surface is unable to tolerate this if sprayed directly on to it.

In this respect, the fact that the Laval nozzle 1 is designed so that the gas undergoes adiabatic expansion as explained above means that it is cooled rapidly during this process and has attained a suitable temperature by the time it reaches the object 15. This temperature is determined by the above-mentioned fan ratio A2 / A1, and may therefore be adjusted at will by varying the design of the nozzle 1. This ability to adjust the temperature of the gas 7 which is sprayed on to the object 15 makes it possible to improve the quality of the coating or other processing.

Moreover, the fact that the highly reactive gas 7 moves at supersonic speed u means that the amount of time required for it to reach the object 15 is very short, so that there is no danger of it reverting from its state of excitation caused by heating and being rendered into plasma to the steady state (a state being difficult to react) before reaching the object 15. In this manner, the state of excitation can be 'frozen' while the temperature is lowered as necessary. This serves to improve the adhesion between the object 15 and the reaction product, and to ensure that there is no peeling of the reaction product or any similar inconvenience, thus improving the quality of the coating or other processing. The speed with which spraying is completed serves to enhance the rate of coating and improve operational efficiency.

The phenomenon which has been described above may be explained as follows with the aid of the theory of first-dimensional gas dynamics.

The relationship between fluid temperature and flow rate in the adiabatic flow of the whole gas may be represented by the following formulae.

$$T_0 = T + (1/2) \cdot \{(\gamma - 1)/\gamma \cdot R\} \cdot u^2 \qquad (1)$$

or

$$T_0 / T = 1 + \{(\gamma - 1)/2\} \cdot M^2 \qquad (2)$$

Here,

T0: Total temperature of the flow (approximately equal to the temperature in the throat section 3 where the heating takes place)
T: Static temperature ( temperature ) of the flow
γ: Ratio of specific heat of the gas
R: Gas constant
u: Flow rate
M: Mach number

Formula (2) is formula (1) rewritten using the Mach number (u / a, a: speed of sound). The Mach number M is determined unconditionally as a function of the fan rate A2 / A1.

Because according to formula (1) the total temperature T0 is retained constant during the adiabatic expansion process, it is clear that the flow rate u increases, while the static temperature T falls. In other words, flow rate and speed of temperature fall are in direct proportion to each other.

Meanwhile, according to formula (2), the value of the thermal ratio T0 / T increases in proportion to the square of the Mach number M. In the case of a diatomic gas (γ = 1.4), for instance, the thermal ratio T0 / T = 6 when the Mach number M = 5. In other words, it is clear that using a Laval nozzle to subject reactive plasma, which has been heated to a high temperature, to adiabatic expansion and acceleration allows the temperature T of the plasma to be reduced to one which suits the object 15. Moreover, because at this stage the plasma particles are very greatly accelerated (eg where T = (1500) K, γ = 1.4, R = 500 (J / kgK) and M = 5, u = 5123 (m / s)), the time required for them to reach the object 15 is very short, and the plasma is able to do so at a low temperature while more or less maintaining its initial active state.

Inasmuch as the highly active low-temperature high-speed plasma flow 7 is delivered on to the object 15 in the form of a particle flux with good directionality, it is further characterized by very highly effective use of the crude gas.

Moreover, as has already been pointed out, there is no admixture into the plasma of impurities originating in the material of which the electrodes are made.

Thus, the device to which the present embodiment pertains not only facilitates the spraying of the object 15 with a high-density highly active gas which is almost entirely free from impurities by lowering to a desired low temperature, but as a result also serves to improve considerably both operational efficiency and quality of processing.

In the present embodiment the coil 5 has been located on the throat section 3, but it is not restricted to this and may be located at will elsewhere on the nozzle 1.

Next, Fig. 2 is a diagram illustrating the configuration of the device illustrated in Fig. 1 to which has been fitted a device whereby it is possible to adjust the outlet pressure P1 of the nozzle 1 in such a manner as to set the pressure ratio P1 / P0 to a desired value.

Those configurational elements which are the same as in Fig. 1 have been allocated the same codes and will not be explained afresh.

As Fig. 2 shows, the throat section 3 and spray pipe 4 are located within a vacuum chamber 8, within which is also located a supporting body 14 which supports the object 15. The air within the vacuum chamber 8 is evacuated by means of an evacuation pump 13. The amount of gas fed to the gas inlet pipe 2 is adjusted with the aid of a gas supply adjustment valve 11 which is fitted to the gas supply pipe 16. The outlet pressure P1 of the spray gas 7 is adjusted with the aid of a P1 adjustment valve 12. The pressure P0 within the gas inlet pipe 2 is detected by means of a P0 measurement gauge 9, while the outlet pressure P1 of the gas spray pipe 4 is detected by means of a P1 measurement gauge 9. The results are fed back, and the pressure ratio P1 / P0 is set to the desired value by adjusting the above-mentioned valves 11, 12 accordingly. It should be added that 17 is a high-frequency power source for the purpose of passing an electric current through the high-frequency induction coil 5.

In an experiment, a mixed gas consisting of $CH_4$ and $H_2$ was used as the gas 6, and a cutting tool chip as the object 15 to be treated. The fan ratio A2 / A1 was set at approximately 6, while the P1 adjustment valve 11 and supply adjustment valve 12 were adjusted so that the pressure within the chamber 8 was about 10 mTorr, and the pressure ratio P1 / P0 about 1.4 / 1000. Under these conditions the Mach number M of the supersonic plasma jet 7 was approximately 5.

A 1 kW 13.56 MHz current was passed through the high-frequency induction coil 5 while cooling.

As a result, a high-density highly reactive gas containing carbon was sprayed at supersonic speed on to the chip 15. The film which was thus formed on the chip 15 adhered to it excellently. Assessment of the film by means of X-ray analysis and Raman spectroscopy showed it to be a good-quality polycrystalline diamond film without any graphite content. Spraying for 5 min yielded a film thickness of 20 $\mu$m.

A diamond coating of this sort considerably improved the durability of the tool chip 15.

Another experiment was performed in which $SiH_4$ or a mixed gas consisting of $SiH_4$ and $H_2$ 6 was used to treat a ceramic substrate 15. All other conditions were the same as above.

In other words, a high-density highly reactive gas containing Si was sprayed on to the substrate 15 to form a Si thin film on the ceramic substrate 15. Assessment of the film by SEM and X-ray analysis showed it to be a fine polycrystalline film. Spraying for 30 min yielded a Si film thickness of about 60 $\mu$m.

In the same manner, it is possible to form a c-BN film by using $NH_3$ and $B_2H_6$ gases as the crude gas 6.

According to the type of crude material 6 used, it is also possible to perform etching, oxidation, nitridation and other forms of surface treatment.

The device to which the present embodiments pertain renders the gas into plasma by heating it with the aid of the high-frequency conduction coil 5, but it is also possible to ECR plasma, helicon plasma and other electrode-less plasma devices.

It is also possible to apply jet shield technology with inactive, crude or diluted gases as normally employed in plasma spraying or plasma welding.

In the device to which the embodiments pertain, all the gas 6 which is to be sprayed on to the treatment surface enters by way of the inlet 2a of the nozzle 1 (Embodiment 1) or the supply pipe 16 and inlet 2a (Embodiment 2), but the position at which the gas 6 is supplied may be selected at will provided that it is upstream from the position of the coil 5 whereby the gas is heated and rendered into plasma.

Meanwhile, when growing a semiconductor film it is necessary to add impurities. In this case, doping agents to form n-type or p-type semiconductors may be mixed with $SiH_4$ or a similar gas, and the resultant mixed gas 6 fed in at a position upstream from the coil 5 where it will be heated and rendered into plasma.

However, the amount of doping agent is very small, so that even if it is fed in separately at a position downstream from the above-mentioned coil 5, this does not inhibit the $SiH_4$ or other gas from undergoing adiabatic expansion. Thus, the doping agent alone may be fed in at a position downstream from where the gas is heated and rendered into plasma.

There follow descriptions of the devices used in each of the first, second, third, fourth and fifth embodiments, which respectively enable the first, second, third, fourth and fifth objects of the present invention to be attained. They all assume the basic configuration illustrated in Fig. 1. Where the same code is used as in Figs. 1 and 2, this is to be taken to signify the same function.

• Device Used in the First Embodiment

As is shown in Fig. 3, this device is configured in such a manner that there is a coating chamber 18 surrounding the outlet section of the gas spray pipe 4 and the substrate 15 to be treated, while a coil chamber 19 surrounds the induction coil 5.

The coating chamber 18 is for forming a semiconductor thin film on the substrate 15, and for adjusting the outlet pressure P1 of the nozzle 1.

The coil chamber 19 serves to adjust the pressure in the vicinity of the coil 5.

The air within both the chambers 18, 19 is evacuated by means of a vacuum pump similar to the evacuation pump 13 illustrated in Fig. 2, while the vacuum within the chamber is adjusted and maintained with the aid of a valve similar to the adjustment valve 12. 20 is a substrate holder for holding the substrate 15.

These chambers 18, 19 are separated spatially.

This first device has the following effect in comparison with the device illustrated in Fig. 2.

That is to say, in the configuration illustrated in Fig. 2 the induction coil 5 for the purpose of heating the gas is located within the same vacuum chamber 8 (coating chamber) as the object 15. This means that when this coating chamber 8 is filled with the crude gas, it becomes impossible to maintain a high degree of vacuum, and irregular discharges tend to occur between the wires of the induction coil 5. The occurrence of such irregular discharges causes the material component of the coil (eg copper) to be sputtered into the coating chamber 8 in the form of impurities.

There is a risk that these impurities may be incorporated into the film during the coating process, thus markedly lowering its performance. In other words, there is a risk that copper and other impurities may adhere to the object 15 to be treated, which is meant to be a semiconductor, and detract from its quality.

What is more, the occurrence of irregular discharges inhibits the stable supply of power to the plasma within the nozzle 1.

In the first device, on the other hand, the chamber 19 for the discharge coil 5 and the coating chamber 18 are separate and configured in such a manner that they each maintain a high degree of vacuum independently. This makes it possible to avoid the scenario whereby the maintenance of a high degree of vacuum in the vicinity of the induction coil 5 is inhibited by the effect of the crude gas and irregular discharges occur. It therefore facilitates a considerable improvement in the quality of the treatment surface, while at the same time permitting a stable supply of power to the plasma within the nozzle 1.

Fig. 4 is a graph illustrating Paschen s law, and shows the relationship between gas pressure and dielectric breakdown voltage. As will be clear from this graph, the dielectric breakdown voltage is high not only on the low-pressure side of the shaded area (high degree of vacuum), but also on the high-pressure side. This means that irregular discharges can be avoided even if conditions of high pressure exist in the vicinity of the induction coil 5, in the same manner as with a high degree of vacuum. Meanwhile, the coating chamber 18 must be maintained at the vacuum pressure indicated by the shaded.

In the configuration illustrated in Fig. 3, it is also possible to leave the coating chamber 18 unchanged and to dispense with the coil chamber 19, so that the induction coil 5 is open to the air. In other words, the device may be configured as is illustrated in Figs. 5 and 6.

• Second Embodiment

In the configuration illustrated in Fig. 6, P0 is the stagnation pressure P0 of the gas 6 at the point of supply, while P1 is the pressure at the outlet of the supersonic nozzle (the pressure within the coating chamber 18). M is the Mach number on the outlet surface of the supersonic nozzle, and $\gamma$ is the ratio of specific heat of the gas 6. In order for a supersonic plasma jet to be sprayed from the nozzle 1, the principles of fluid dynamics require that the conditions of the following formula (3) be fulfilled.

$$\frac{P_1}{P_0} < f(M) \quad f(M) = \left(1 + \frac{\gamma-1}{2}M^2\right)^{\frac{-\gamma}{\gamma-1}} \left[\frac{2\gamma M^2 - (\gamma-1)}{\gamma+1}\right] \quad (3)$$

If the conditions of the above formula (3) are not fulfilled and $P1 / P0 = f(M)$, vertical shockwaves 7a are formed on the outlet surface of the supersonic nozzle, as Fig. 6 shows, and the plasma jet becomes a subsonic jet 7'. This leads to a marked lowering of the performance of the coating and poor quality of the substrate 15.

Similarly, if the conditions of the above formula (3) are not fulfilled and $P1 / P0 > f(M)$, vertical shockwaves 7a are formed inside the supersonic nozzle, and the plasma jet becomes a subsonic jet 7'. This again leads to poor quality of the substrate 15.

The device to which the present embodiment pertains is configured as illustrated in Fig. 5, and the pressure P0 is controlled in such a manner that the conditions of the above formula (3) are realized.

The device illustrated in Fig. 5 ensures that the conditions of the above formula (3) are fulfilled by controlling the flow rate of the gas 6 supplied to the supersonic nozzle 1.

In other words, it has a pressure sensor 21 within the gas inlet pipe 2, and this detects the stagnation pressure P0. There is also a pressure sensor 22 within the coating chamber 18. This serves to detect the pressure at the outlet of the supersonic nozzle (the pressure within the coating chamber 18). The output from these pressure sensors 21, 22 is fed into a divider 23.

The divided 23 executes the calculation P1 / P0, and feeds the result of this calculation to the plus terminal of a comparator 25. Meanwhile, a function generator 24 feeds the function f (M) to the minus terminal of the comparator 23.

As a result, the comparator 23 outputs to a motor 26 a drive signal corresponding to the deviation P1 / P0 - f (M) , which is to say a drive signal enabling the conditions of the above formula (3) to be fulfilled.

The motor 26 drives the gas supply adjustment valve 11, which is fitted to the gas supply pipe 16, according to the above-mentioned drive signal, adjusting the degree of opening of the valve and controlling the amount of gas supplied to the gas supply pipe 2.

As a result, the stagnation pressure P0 within the gas supply pipe 2 is altered to a value which permits the conditions of the above formula (3) to be fulfilled.

Moreover, by altering the value of the stagnation pressure P0 it is possible to generate thermally balanced and unbalanced plasma as required.

That is to say, it is possible to generate thermally balanced plasma by setting the stagnation pressure P0 at a high value close to atmospheric pressure, while setting it low in the tens of Torrs allows thermally unbalanced plasma to be generated. This may be implemented as desired in accordance with the object of the coating and the required quality.

The device illustrated in Fig. 5 is configured in such a manner as to control the stagnation pressure P0, but it is also possible to fulfil the conditions of the above formula (3) by controlling the nozzle outlet pressure P1, or by controlling both pressures P0, P1.

Thus, the second embodiment, by controlling the pressures P0, P1, makes it possible to ensure that the plasma jet is supersonic, thus permitting a considerable improvement in the quality of the treatment surface.

• Third Embodiment

The device illustrated in Fig. 7 (a) allows the reaction efficiency to be improved by increasing the speed at which the plasma jet 7 is sprayed on to the object 15 to be treated, thus serving to increase the quality of the object 15.

The device illustrated in Fig. 7 (a) employs electrodes in order to impart an electrical bias to the plasma, thus injecting additional energy into it and increasing the speed of the plasma jet 7.

As Fig. 7 (a) shows, an electrode 28 is located inside the gas inlet tube 2 of the supersonic nozzle 1 in such a manner as to come into contact with the plasma gas 27. The electrode 28 may be either flat or rod-shaped.

Meanwhile, the substrate holder 20 is made of a material which allows it to function also as an electrode, and the plasma current 27 flows into it through the substrate 15 which is ITO.

These electrodes 28, 20 are connected to an alternating-current power supply 33, by means of which the desired voltage is applied between them. A variable resistance 34 allows the current to be adjusted.

A direct-current power supply may also be used instead of the alternating-current power supply 33.

The plasma current A flowing between the electrodes 28, 20 is detected by means of an ammeter 32. The current A detected by the ammeter 32 is fed by way of a current-voltage converter 31 to the minus terminal of a comparator 30. Meanwhile, a reference current value $A_{ref}$ is imparted to the plus terminal of the comparator 30. This reference current value $A_{ref}$ is set in accordance with the desired speed of the plasma jet 7.

• First Control

A drive signal corresponding to the deviation $A_{ref}$ - A, namely a drive signal for the purpose of rendering the plasma current A into the desired current value $A_{ref}$, is output from the comparator 30 to a drive unit 29.

The drive unit 29 comprises among other elements a motor which causes the electrode 28 to move in the direction of flow of the plasma gas 27.

Thus, when the drive unit 29 is driven in accordance with the above-mentioned drive signal, the electrode 28 moves in accordance with the drive signal either in the downstream direction of the gas flow indicated by the arrow B (direction in which the plasma current increases), or in the upstream direction indicated by the arrow B' (direction in which the plasma current decreases). The position is finally determined as the one where the plasma current tallies with the desired value $A_{ref}$.

In this manner, as is shown in Fig. 9, this first control allows both the electrodes 28, 20 to come into contact with the plasma gas 27. Voltage is applied on to the plasma gas 27 by means of the power source 33, and a current circuit 50 is formed. Consequently, the current is excited within the plasma, causing the current to flow on to the substrate 15. The plasma particles are accelerated, the reaction efficiency on the surface of the substrate 15 is enhanced, and as a result the quality of the substrate improves.

• Second Control

By impressing the voltage only on the plasma gas 27 it is possible also to accelerate the plasma particles without allowing the current to flow on to the substrate 15.

In this case, the electrode 28 in the device illustrated in Fig. 7 (a) is retracted in the upstream direction B' to ensure that the value of the plasma current is below the reference current value $A_{ref}$.

Thus, as Fig. 8 shows, the electrode 28 is positioned where it will not come into contact with the plasma gas 27.

This second control not only permits the plasma particles to accelerate as a result of the electrical field generated by the power source 33, thus enhancing the quality of the substrate in the same manner as the first control, but also ensures freedom from the inconvenience of having the current flow on to the substrate 15.

In other words, while the current flowing on to the substrate 15 can in certain circumstances serve to improve the quality of the film on the substrate 15, it can also have the opposite effect.

In such cases, use of the second control is effective.

Moreover, this third embodiment has utilized the electrode 20 on the downstream side of the gas flow as a substrate holder, but as the cross-section in Fig. 7 (b) shows, it is also possible to provide a ring-shaped electrode 35 separately from the substrate holder 20.

• Fourth Embodiment

It is sometimes necessary to form a metal or metal compound film on the substrate 15. However, inasmuch as metals and metal compounds cannot be gasified, it is impossible to spray them on to the substrate 15 in the form of a gas, and the device illustrated in Fig. 1 cannot be applied without modification.

Nevertheless, it becomes possible to form a metal or metal compound film of the device is configured as shown in Fig. 10.

In other words, as Fig. 10 shows, a carrier gas 6' (eg argon, hydrogen, oxygen) is employed in order to transport to the substrate 15 the material (eg barium titanate) which is to be applied to its surface. This carrier gas 6' is fed into the supersonic nozzle 1 from its inlet, while electrodes 36, 37 consisting of the above-mentioned crude material are located within the gas inlet pipe 2 of the supersonic nozzle 1 (downstream from the position where the carrier gas 6' is fed in).

A prescribed voltage is applied on the electrodes 36, 37 by means of a power source 41, and a discharge 38 (eg arc discharge, glow discharge) executed between them, as a result of which the crude material is emitted in the form of metal atoms or clusters and mixes with the carrier gas 6'. The carrier gas 6' with its admixture of the crude material is heated and rendered into plasma in the throat section 3, and this heated plasma gas 7 is sprayed from the nozzle outlet on to the surface of the substrate 15.

In this case, it is vital to ensure a uniform admixture of the crude material in order that the quality of the film on the substrate 15 should also be uniform. For this reason the discharge distance d between the electrodes 36, 37 must be controlled so as to meet the desired constant value $d_{ref}$.

The distance d varies as a result of wear to the electrodes 36, 37. In order to ensure that it tallies with the constant value $d_{ref}$, the electrodes 36, 37 are provided with drive mechanisms 39, 40 respectively, which allow them to move.

Inasmuch as variations in the distance d can be confirmed by detecting the discharge voltage V between the electrodes 36, 37, a voltmeter 42 is provided for the purpose of detecting the discharge voltage V. The output of the voltmeter 42 is fed to the plus terminal of a comparator 43. Meanwhile, a reference voltage $V_{ref}$ corresponding to the desired discharge distance $d_{ref}$ is input to the minus terminal of the comparator 43.

A drive signal corresponding to the deviation V - $V_{ref}$ is then output from the comparator 43 in order to ensure that the discharge voltage tallies with the desired value $V_{ref}$, and this is fed to motors 44, 45 which drive the drive mechanisms 36, 37 respectively.

The motors 44, 45 drive the drive mechanisms 39, 40, allowing the electrodes 36, 37 to move in the direction C and thus altering the distance d, and the electrodes 36, 37 are positioned in such a manner as to obtain the desired discharge distance d corresponding to the voltage $V_{ref}$.

In this manner, the fourth embodiment makes it possible to form metal and other coatings by spraying metals and metal compounds, which are incapable of gasification, on to the substrate 15.

• Fifth Embodiment

There is a demand for improved crystallization of the coating on the substrate 15. Improved crystallization can be achieved by ensuring that the plasma particles reach the treatment surface 15 in a regular manner.

The fifth embodiment is designed to improve crystallization of the coating on the substrate 15 by ensuring that the plasma particles reach the surface of the object 15 in a regular manner.

In other words, as Fig. 11 shows, a coil 46 for generating a magnetic field is located between the outlet of the supersonic nozzle 1 and the substrate 15 in order that mutually parallel lines of attraction 47a, 47b, 47c ... may be formed in the direction of the flow of the plasma gas 7.

Since the plasma particles move along lines of attraction, the fact that the lines of attraction 47a, 47b, 47c ... are mutually parallel means that the movement of the plasma particles will be regular and parallel, and that they will reach the surface of the substrate 15 in a regular manner. This serves to improve the crystallization of the coating.

In this case, by altering as required the strength of the magnetic field (density of the lines of attraction) which is applied by means of the coil 46, it is possible to ensure that the movement of the plasma particles corresponds to the lattice constant of the coating crystals. In this manner it is possible to optimize crystallization by altering the strength of the magnetic field in accordance with the type of coating (in accordance with the magnitude of the lattice constant).

Embodiments 1-5 as described above may be suitably combined.

For instance, it is possible to combine the first, second or third embodiments with the third embodiment, and the first, second, third or fourth embodiments with the fifth embodiment.

As has been explained above, the first embodiment, by ensuring the absence of irregular discharges in the induction coil, allows the quality of the treatment surface to be enhanced and facilitates the stable supply of power to the plasma within the nozzle.

The second embodiment, by making it possible to adjust the pressure at the inlet or outlet of the nozzle in order to ensure that the plasma jet is supersonic, allows the quality of the treatment surface to be enhanced.

The third embodiment, by injecting additional energy into the plasma to increase the speed of the plasma jet, allows the quality of the treatment surface to be enhanced.

The fourth embodiment, by making it possible to spray the treatment surface with metal or metal compounds which are incapable of gasification, facilitates the formation of metal or metal compound coatings.

The fifth embodiment, by ensuring that the plasma particles reach the treatment surface in a regular manner, allows the crystallization of the coating on the treatment surface to be improved.

INDUSTRIAL APPLICABILITY

The present invention can be applied not only to the formation of coatings, but to any type of surface treatment which is executed by spraying gas.

**Claims**

1. A surface treatment apparatus using gas jet, for treating a surface of an object to be treated by spraying gas onto the surface of the object, characterized in that the apparatus comprises:

   a supersonic nozzle which subjects gas passing through an interior of the nozzle to adiabatic expansion and sprays the gas from an outlet of the nozzle at a flow rate greater than a speed of sound;
   an induction coil located on an outside partway along a pipe line of the supersonic nozzle, which heats the gas passing through the nozzle and renders the gas into plasma;
   supply means for supplying gas which is to be sprayed onto the surface of the object into the supersonic nozzle from an inlet of the nozzle or a gas supply position upstream along a path of gas flow from a position where the induction coil is located; and
   heating means for heating and rendering the supplied gas into plasma by passing an electrical current through the induction coil,
   the gas, having been heated and rendered into plasma, being sprayed from the outlet of the nozzle toward the surface of the object to be treated; and
   chambers for adjusting a pressure at the outlet of the nozzle and a pressure in a vicinity of the conduction coil being further provided, the former in such a manner as to surround the outlet of the nozzle and the object to be treated, and the latter in such a manner as to surround the induction coil, the two chambers being separate.

2. A surface treatment apparatus using gas jet, for treating a surface of an object to be treated by spraying gas onto the surface of the object, characterized in that the apparatus comprises:

   a supersonic nozzle which subjects gas passing through an interior of the nozzle to adiabatic expansion and sprays the gas from an outlet of the nozzle at a flow rate greater than a speed of sound;
   an induction coil located on an outside partway along a pipe line of the supersonic nozzle, for heating the gas passing through the interior of the nozzle and rendering the gas into plasma, by being applied with an electric current;
   supply means for supplying gas which is to be sprayed onto the surface of the object into the supersonic nozzle from an inlet of the nozzle or a gas supply position upstream along a path of gas flow from a position where the induction coil is located; and
   heating means for heating and rendering the supplied gas into plasma by passing the electrical current through the induction coil,
   the gas, having been heated and rendered into plasma, being then sprayed from the outlet of the nozzle toward the surface of the object to be treated, and
   a chamber for adjusting a pressure at the outlet of the nozzle being further provided in such a manner as to surround the outlet of the nozzle and the object to be treated, while the induction coil being open to the air.

3. A surface treatment apparatus using gas jet, for treating a surface of an object to be treated by spraying gas onto the surface of the object, characterized in that the apparatus comprises:

   a supersonic nozzle which subjects gas passing through an interior of the nozzle to adiabatic expansion and sprays the gas from an outlet of the nozzle at a flow rate greater than a speed of sound;
   heating means located on a partway of a pipe line of the supersonic nozzle, for heating the gas passing through the interior of the nozzle and rendering the gas into plasma; and
   supply means for supplying gas which is to be sprayed onto the surface of the object into the supersonic nozzle from an inlet of the nozzle or a gas supply position upstream along a path of gas flow from a position where the heating means is located,
   the gas, having been heated and rendered into plasma with the aid of the heating means, being then sprayed from the outlet of the nozzle toward the surface of the object to be treated, and
   values of pressures P0 and P1 being adjusted so as to fulfill the following formula, where P0 is a stagnation pressure of the gas at a point of supply, P1 is a pressure at the outlet of the supersonic nozzle, M is a Mach number on the outlet surface of the supersonic nozzle, and $\gamma$ is a ratio of specific heat of the gas:

$$\frac{P_1}{P_0} < \left(1+\frac{\gamma-1}{2}M^2\right)^{\frac{-\gamma}{\gamma-1}}\left[\frac{2\gamma M^2-(\gamma-1)}{\gamma+1}\right]$$

4. The surface treatment apparatus according to Claim 3, wherein the formula is fulfilled by controlling the flow rate of the gas supplied into the supersonic nozzle.

5. A surface treatment apparatus using gas jet, for treating a surface of an object to be treated by spraying gas onto the surface of the object, characterized in that the apparatus comprises:

a supersonic nozzle which subjects gas passing through an interior of the nozzle to adiabatic expansion and sprays the gas from an outlet of the nozzle at a flow rate greater than a speed of sound;
heating means located on a partway of a pipe line of the supersonic nozzle, for heating the gas passing through the interior of the nozzle and rendering the gas into plasma; and
supply means for supplying gas which is to be sprayed onto the surface of the object into the supersonic nozzle from an inlet of the nozzle or a gas supply position upstream along a path of gas flow from a position where the heating means is located,
the gas, having been heated and rendered into plasma with the aid of the heating means, being then sprayed from the outlet of the nozzle toward the surface of the object to be treated,
electrodes being provided at the inlet of the supersonic nozzle and downstream of the outlet of the nozzle respectively in such a manner as to come into contact with the plasma gas, and
voltage applying means being provided for applying a prescribed voltage across the electrodes.

6. The surface treatment apparatus according to Claim 5, further comprising driving means for moving the electrode at the inlet of the supersonic nozzle in a direction of a flow of the plasma gas and detection means for detecting a plasma current, wherein the electrode at the inlet of the supersonic nozzle is moved with the aid of the driving means in such a manner that the plasma current attains a desired value.

7. A surface treatment apparatus using gas jet, for treating a surface of an object to be treated by spraying gas onto the surface of the object, characterized in that the apparatus comprises:

a supersonic nozzle which subjects gas passing through an interior of the nozzle to adiabatic expansion and sprays the gas from an outlet of the nozzle at a flow rate greater than a speed of sound;
heating means located on a partway of a pipe line of the supersonic nozzle, for heating the gas passing through the interior of the nozzle and rendering the gas into plasma; and
supply means for supplying gas which is to be sprayed onto the surface of the object into the supersonic nozzle from an inlet of the nozzle or a gas supply position upstream along a path of gas flow from a position where the heating means is located,
the gas, having been heated and rendered into plasma with the aid of the heating means, being then sprayed from the outlet of the nozzle toward the surface of the object to be treated,
an electrode being provided downstream from the outlet of the supersonic nozzle in such a manner as to come into contact with the plasma gas,
an electrode being provided at the inlet of the supersonic nozzle in such a manner as not to come into contact with the plasma gas, and
voltage applying means being provided for applying a prescribed voltage across the electrodes.

8. A surface treatment apparatus using gas jet, for treating a surface of an object to be treated by spraying gas onto the surface of the object, characterized in that the apparatus comprises:

a supersonic nozzle which subjects gas passing through an interior of the nozzle to adiabatic expansion and sprays the gas from an outlet of the nozzle at a flow rate greater than a speed of sound;
heating means located on a partway of a pipe line of the supersonic nozzle, for heating the gas passing through the interior of the nozzle and rendering the gas into plasma;
supply means for supplying a carrier gas, which transports to the object a raw material to be adhered to the surface of the object, into the supersonic nozzle from an inlet of the nozzle or a gas supply position upstream along a path of gas flow from a position where the heating means is located;
two electrodes located downstream from the position at which the carrier gas is fed in and comprising the raw material; and
discharge means for effecting a discharge across the two electrodes,

the raw material, having been discharged from the two electrodes, being incorporated into the carrier gas, the carrier gas with the incorporated raw material being then heated with the aid of the heating means and rendered into plasma, and the plasma gas being sprayed from the outlet of the nozzle toward the surface of the object.

9. A surface treatment apparatus according to Claim 8, further comprising driving means for moving the two electrodes so as to change a distance between them, and detection means for detecting a discharge voltage between the two electrodes, wherein the two electrodes are moved with the aid of the driving means in such a manner that the discharge voltage attains a desired value.

10. A surface treatment apparatus using gas jet, for treating a surface of an object to be treated by spraying gas onto the surface of the object, characterized in that the apparatus comprises:

a supersonic nozzle which subjects gas passing through an interior of the nozzle to adiabatic expansion and sprays the gas from an outlet of the nozzle at a flow rate greater than a speed of sound;

heating means located on a partway of a pipe line of the supersonic nozzle, for heating the gas passing through the interior of the nozzle and rendering the gas into plasma;

supply means for supplying gas which is to be sprayed onto the surface of the object into the supersonic nozzle from an inlet of the nozzle or a gas supply position upstream along a path of gas flow from a position where the heating means is located,

the gas, having been heated and rendered into plasma with the aid of the heating means, being then sprayed from the outlet of the nozzle toward the surface of the object to be treated, and

a magnetic field generating coil being provided for forming mutually parallel magnetic lines in a direction of a flow of the plasma gas between the outlet of the supersonic nozzle and the object to be treated.

# FIG.1

# FIG.2

# FIG.3

COIL CHAMBER
19

17

1

COATING CHAMBER
18

6
2
4
7

5

20 SUBSTRATE HOLDER

15

TO VACUUM PUMP

TO VACUUM PUMP

# FIG.4

DIELECTRIC BREAKDOWN VOLTAGE (RELATIVE VALUE)

COATING CHAMBER PRESSURE AREA

$10^{-2}$ $10^{-1}$ $10^{0}$ $10^{1}$ $10^{2}$ $10^{3}$

GAS PRESSURE (Torr)

# FIG.5

PRESSURE SENSOR

$P_0$

$P_1$

PRESSURE SENSOR

TO VACUUM PUMP

f(M)

$P_1 / P_0$

23 DIVIDER

# FIG.6

$P_0$

$P_1$

TO VACUUM PUMP

# FIG.7(a)

# FIG.7(b)

# FIG.8

# FIG.9

# FIG.10

# FIG.11

MAGNETIC FIELD
GENERATING COIL
46

15
20
47a
47b
47c

MAGNETIC FIELD
GENERATING COIL
46

# INTERNATIONAL SEARCH REPORT

| International application No. |
|---|
| PCT/JP96/02401 |

**A. CLASSIFICATION OF SUBJECT MATTER**

Int. Cl$^6$ C23C16/50, C23C14/24, C30B25/02, B01J19/08, H01L21/205

According to International Patent Classification (IPC) or to both national classification and IPC

**B. FIELDS SEARCHED**

Minimum documentation searched (classification system followed by classification symbols)

Int. Cl$^6$ C23C16/50, C23C14/24, C30B25/02, B01J19/08, H01L21/205

Documentation searched other than minimum documentation to the extent that such documents are included in the fields searched

| | |
|---|---|
| Jitsuyo Shinan Koho | 1926 - 1996 |
| Kokai Jitsuyo Shinan Koho | 1971 - 1995 |
| Toroku Jitsuyo Shinan Koho | 1994 - 1996 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP, 63-16043, A (Canon Inc.), January 23, 1988 (23. 01. 88)(Family: none) | 3, 4 |
| Y | JP, 63-16043, A (Canon Inc.), January 23, 1988 (23. 01. 88)(Family: none) | 1, 2, 5, 8, 10 |
| Y | JP, 52-44174, A (Hitachi, Ltd.), April 6, 1977 (06. 04. 77), Page 2, lower left column, line 4 to page 3, upper right column, line 1; Fig. 2 & US, 4123316, A & GB, 1550853, A | 1, 2, 5 |
| Y | JP, 5-171427, A (Multi Ark Scientific Cortings), July 9, 1993 (09. 07. 93), Claim 7; column 7, line 28 to column 9, line 24; Fig. 1 & EP, 511153, A & US, 5458754, A | 8 |
| Y | JP, 4-180221, A (Kobe Steel, Ltd.), June 26, 1992 (26. 06. 92), Claim; page 3, lower left column, line 19 to page 4, lower left column, line 9; Figs. 1 to 3 | 10 |

☒ Further documents are listed in the continuation of Box C.　　☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| November 20, 1996 (20. 11. 96) | November 19, 1996 (19. 11. 96) |

| Name and mailing address of the ISA/ | Authorized officer |
|---|---|
| Japanese Patent Office | |
| Facsimile No. | Telephone No. |

Form PCT/ISA/210 (second sheet) (July 1992)

INTERNATIONAL SEARCH REPORT

International application No.

PCT/JP96/02401

C (Continuation).    DOCUMENTS CONSIDERED TO BE RELEVANT

| Category* | Citation of document, with indication, where appropriate, of the relevant passages | Relevant to claim No. |
|---|---|---|
| | (Family: none) | |
| A | JP, 63-16043, A (Canon Inc.),<br>January 23, 1988 (23. 01. 88)(Family: none) | 6, 7, 9 |
| A | JP, 4-116172, A (Energy Conversion Devices, Inc.),<br>April 16, 1992 (16. 04. 92)<br>& EP, 470274, A & US, 5093149, A | 1 - 10 |
| P | JP, 8-990, A (Komatsu Ltd.),<br>January 9, 1996 (09. 01. 96)<br>& WO, 9534376, A | 1 - 10 |

Form PCT/ISA/210 (continuation of second sheet) (July 1992)